Europäisches Patentamt

(19) European Patent Office

Office européen des brevets

(11) Numéro de publication: **0 308 305**
**A1**

(12) **DEMANDE DE BREVET EUROPEEN**

(21) Numéro de dépôt: 88402280.7

(22) Date de dépôt: 09.09.88

(51) Int. Cl.⁴: **H 01 L 39/12**
H 01 L 39/24, C 04 B 35/00

(30) Priorité: 15.09.87 FR 8712775

(43) Date de publication de la demande:
22.03.89 Bulletin 89/12

(84) Etats contractants désignés:
CH DE GB IT LI NL SE

(71) Demandeur: THOMSON-CSF
173, Boulevard Haussmann
F-75379 Paris Cédex 08 (FR)

(72) Inventeur: Kormann, René Albert
THOMSON-CSF SCPI 19, avenue de Messine
F-75008 Paris (FR)

Loiseau, Raymond
THOMSON-CSF SCPI 19, avenue de Messine
F-75008 Paris (FR)

Marcilhac, Bruno
THOMSON-CSF SCPI 19, avenue de Messine
F-75008 Paris (FR)

(74) Mandataire: Grynwald, Albert et al
THOMSON-CSF SCPI 19, avenue de Messine
F-75008 Paris (FR)

(54) Matériau supraconducteur.

(57) L'invention concerne un matériau supraconducteur constitué essentiellement d'un oxyde fluoré de baryum, de calcium et de cuivre. Ce matériau présente l'intérêt de fournir une transition résistive nettement abrupte.

Application à la fabrication de dispositifs électrotechniques et électroniques.

EP 0 308 305 A1

**Description**

## Matériau supraconducteur

L'invention concerne un matériau supraconducteur présentant une transition supraconductrice abrupte.

Une des propriétés des matériaux supraconducteurs est la variation de leur résistance électrique lorsqu'on fait décroître la température. Actuellement, les études en cours visent à obtenir des matériaux qui deviennent supraconducteurs à des températures de plus en plus élevées et qui tendent vers la température ambiante.

La transition résistive ou largeur de la transition caractérise la différence entre l'état de la température "ONSET" à laquelle le matériau commence à s'écarter de l'état à haute température et l'état à la température à laquelle le matériau possède une résistance quasiment nulle. Il est à souligner qu'il est intéressant que cette transition résistive soit la plus abrupte possible c'est-à-dire que la largeur de transition soit la plus faible possible.

L'invention fournit un matériau répondant à cette exigence.

L'invention concerne un matériau supraconducteur caractérisé en ce qu'il est constitué essentiellement par un oxyde fluoré de baryum, de calcium et de cuivre.

L'invention concerne également un procédé de réalisation d'un matériau supraconducteur, caractérisé en ce qu'il comporte les étapes suivantes :
- mélange de poudres de carbonate de calcium ($CaCO_3$), de carbonate de baryum ($BaCO_3$), de fluorure de baryum ($BaF_2$) et d'oxyde de cuivre ($CuO$) ;
- compactage sous pression de la poudre ;
- frittage sous oxygène.

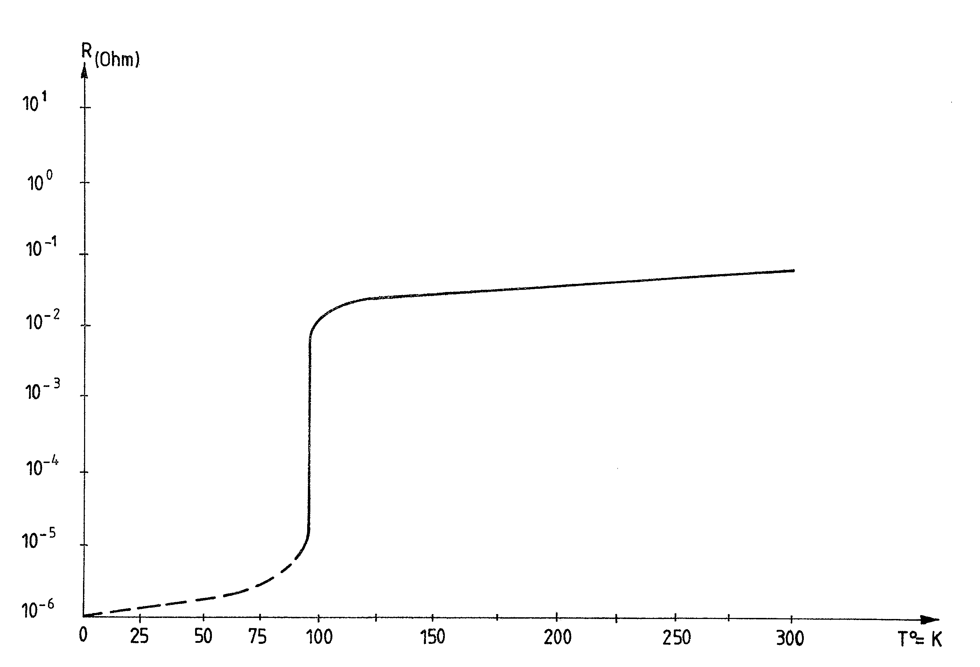

Les différents objets et caractéristiques de l'invention apparaîtront plus clairement dans la description qui va suivre faite à titre d'exemple en se reportant à la figure annexée qui représente une courbe mettant en évidence la transition résistive du matériau selon l'invention.

Le matériau selon l'invention est constitué d'oxydes métalliques ne contenant pas de terre rare. Il se différencie ainsi nettement des matériaux supraconducteurs connus par le fait qu'il ne contient pas de terre rare et notamment ni Lanthane, ni Yttrium.

Plus précisément les matériaux de l'invention possèdent une composition en moles du type :
$Ba_2 Ca Cu_3 O_{7-x} Fy$

Dans cette composition, les paramètres x et y ont des valeurs comprises entre 0 et 1.

Des mesures effectuées sur de tels matériaux ont permis de mettre en évidence la transition abrupte de passage à l'état supraconducteur du matériau sur la caractéristique de résistance en fonction de la température.

Sur la figure annexée on trouve la courbe représentative de la variation de la résistance exprimée en ohm en fonction de la température exprimée en degrés Kelvin. Aux très faibles valeurs de résistances, c'est-à-dire à très faible température, les valeurs des résistances difficiles à mesurer ont été représentées en pointillés.

La transition résistive nettement abrupte présente un intérêt pour l'utilisation. Dans les matériaux connus la température de transition Tc appelée température critique est difficile à situer entre la température "ONSET", située à la partie supérieure de la transition sur la caractéristique résistance/température, et la température "OFFSET" à laquelle le matériau est réellement à l'état supraconducteur. Par contre le matériau selon l'invention présente une transition brutale. Les températures d'ONSET et d'OFFSET diffèrent peu et la température critique est située à une température que très légèrement plus faible que la température "ONSET". C'est ainsi que par exemple, la température d'ONSET a été trouvée égale à 100°K et la température d'OFFSET à 97°K.

La caractéristique de la figure annexée a été réalisée avec un échantillon placé dans un cryostat. Les valeurs ont été mesurées en quatre points en utilisant un nanovoltomètre et un générateur de courant de mesure.

Les matériaux de l'invention trouveront une application préférentielle dans la fabrication des dispositifs électrotechniques (aimant supraconducteur, conducteur électrique) et en électronique tels que dans les composants utilisant l'effet Josephson, guides d'ondes, les cavités résonnantes.

L'invention prévoit de réaliser le matériau supraconducteur ainsi décrit à partir de
- carbonate de calcium
- carbonate de baryum
- fluorure de baryum
- oxyde de cuivre.

Les différentes étapes du procédé de réalisation selon l'invention sont les suivantes :
- pesée des matières premières qui sont le carbonate de calcium ($CaCO_3$), le carbonate de baryum ($BaCO_3$), le fluorure de baryum $BaF_2$ et l'oxyde de cuivre ($CuO$).
- mélange dans une pulvérisette dans les proportions suivantes :
. 1,2132 grammes de $BaF_2$
. 4,1062 grammes de $BaCO_3$
. 1,4473 grammes de $CaCO_3$
. 3,3060 grammes de $CuO$
. 20 cc d'alcool éthylique ou de liquide volatile,
. durée 30 minutes.
- séchage
- tamisage 400 microns,
- compactage de la poudre $2T/cm^2$ dans un moule en acier de diamètre 18mm.
- frittage sous oxygène :
. montée à 100°C/h,
. palier à 500°C pendant 4h,
. descente à 100°C/h,

Il est bien évident que la description qui précède n'a été faite qu'à titre d'exemple non limitatif. D'autres variantes peuvent être envisagées sans sortir du cadre de l'invention. Les exemples numériques et les produits employés dans la réalisation du matériau selon l'invention n'ont été fournis que pour illustrer la description.

## Revendications

1. Matériau supraconducteur caractérisé en ce qu'il est constitué essentiellement par un oxyde fluoré de baryum, de calcium et de cuivre.

2. Matériau supraconducteur selon la revendication 1, caractérisé en ce que sa composition est du type $Ba_2 Ca Cu_3 O_{7-x}F_y$ les valeurs de x et y étant comprises entre 0 et 1.

3. Procédé de réalisation d'un matériau supraconducteur selon la revendication 1, caractérisé en ce qu'il comporte les étapes suivantes :
- mélange de poudres de carbonate de calcium ($Ca CO_3$), de carbonate de baryum ($Ba CO_3$), de fluorure de baryum ($Ba F_2$) et d'oxyde de cuivre ($CuO$) ;
- compactage sous pression de la poudre ;
- frittage sous oxygène.

4. Procédé selon la revendication 3, caractérisé en ce que le mélange des différentes poudres de carbonates et d'oxyde est réalisé dans un liquide volatile et qu'un séchage de la poudre est réalisé après le mélange et avant le chamottage.

5. Procédé selon la revendication 3, caractérisé en ce que l'étape de compactage est précédée d'une étape de tamisage.

6. Procédé selon la revendication 3, caractérisé en ce que l'étape de frittage se fait selon un cycle de températures pouvant atteindre 1200° C.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | ADVANCED CERAMIC MATERIALS - CERAMIC SUPERCONDUCTORS volume 2, no. 3B, juillet 1987, pages 444-456, Westerville, US; C.W. GRABTREE et al.: "Fabrication mechanical properties, heat capacity, oxygen diffusion and the effect of alkali earth ion substitution on height Tc superconductors" * paragraphe II * | 3 | H 01 L  39/12 H 01 L  39/24 C 04 B  35/00 |
| A | JAPANESE JOURNAL OF APPLIED PHYSICS volume 20, no. 4, avril 1981, pages L264-L266, Tokyo, JP; T. INUKAI et al.: "Li-Ti-O superconducting compounds prepared by hot-pressing" * paragraphe 2 * | 3 | |
| A | MATERIAL RESEARCH BULLETIN volume 18, 1983, pages 181-186; J.G. BEDNORZ et al.: "Phase diagram of the $(LaA1O3)1-x (SrTiO3)x$ solid solution system for x inf. or equal to 0,8" * en entier * | | DOMAINES TECHNIQUES RECHERCHES (Int. Cl.4) H 01 L  39/00 |
| A | PHYSICAL REVIEW B volume 29, no. 3, February 1984, pages 1493-1496, New York, US; T.H. LIN et al.: "Observation of a reentrant superconducting resistive transition in granular $BaPbO.75BiO.25/O3$ superconductor" * page 1493 * -/- | 1,3 | |

Le présent rapport a été établi pour toutes les revendications

| Lieu de la recherche | Date d'achèvement de la recherche | Examinateur |
|---|---|---|
| BERLIN | 05-12-1988 | ROUSSEL A T |

EPO FORM 1503 03.82 (P0402)

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | KERNFORSCHUNGSZENTRUM-KARLSRUHE-NACHRICHTEN<br>19e année, volume 3, 1987, pages 119-129; C. POLITIS "Die Suche nach der Hochtemperatursupraleitung" * page 119; page 126 *<br>--- | 1 | |
| P,A | L'ONDE ELECTRIQUE<br>volume 68, no. 1, janvier 1988, page 16, Paris, FR; "Le laboratoire Philips aux USA découvre un supraconducteur stable à température plus élevée" * en entier *<br>----- | 1 | |

DOMAINES TECHNIQUES RECHERCHES (Int. Cl.4)

Le présent rapport a été établi pour toutes les revendications

| Lieu de la recherche | Date d'achèvement de la recherche | Examinateur |
|---|---|---|
| BERLIN | 05-12-1988 | ROUSSEL A T |